# DEMANDE DE BREVET EUROPEEN

(11) **EP 0 660 495 A1**
(43) Date de publication de la demande: **28.06.1995**
(21) Numéro de dépôt: 94402970.1
(22) Date de dépôt: 21.12.1994
(51) Int. Cl.: H02M 1/00, H02M 7/5387, H02P 7/00, H03K 17/61

(54) **Système de commande d'actionneurs à courant continu en électronique de puissance**

(30) Priorité: 23.12.1993 FR 9315564
(71) Demandeur: COMMISSARIAT A L'ENERGIE ATOMIQUE, F-75015 Paris (FR)
(72) Inventeur: Basire, Alain, F-78000 Versailles (FR); Marceau, Michel, F-78490 Montfort l'Amaury (FR)
(74) Mandataire: Dubois-Chabert, Guy

(57) **Abrégé**

L'invention concerne un système de commande d'actionneurs à courant continu en électronique de puissance, basé sur la modulation de largeur d'impulsion, comprenant un pont en H de quatre interrupteurs, chaque interrupteur comportant un transistor bipolaire (T1, T2, T3, T4) et une diode (D1, D2, D3, D4) branchée en parallèle inverse entre l'émetteur et le collecteur de celui-ci, et un circuit de commande (11) de ces transistors. Le circuit de commande (11) délivre quatre signaux (V1, V2, V3, V4) permettant de décaler dans le temps la commutation de ces quatre transistors (T1, T2, T3, T4) de manière à ce que lors d'une commutation de l'un de ceux-ci aucun couple de transistors ne soit rendu conducteur simultanément, tant en ce qui concerne des transistors appartenant à deux branches latérales du pont, qu'en ce qui concerne des transistors appartenant à deux branches opposées de ce pont.

## Description

### Domaine technique

L'invention concerne un système de commande d'actionneurs à courant continu en électronique de puissance.

### Etat de la technique antérieure

Dans le domaine de la commande d'actionneurs à courant continu la technique communément employée est celle de la modulation par largeur d'impulsion (MLI ou PWM en anglais). Celle-ci permet l'amélioration du rendement de l'amplificateur de manière considérable par rapport aux techniques classiques d'amplification linéaire. Mais la mise en oeuvre de cette technique est délicate en raison du comportement des éléments de puissance en commutation. Des montages électroniques plus ou moins complexes sont employés et une quantité importante d'énergie est perdue dans les dissipateurs.

Le manuel d'application constructeur de Unitrode intitulé "Linear and Integrated Circuits Data and Application Handbook" (avril 1990) décrit notamment un système de commande d'actionneurs à courant continu, en utilisant quatre interrupteurs montés sous forme de pont en H, la charge étant au centre du H. Ces interrupteurs sont réalisés par des transistors de type MOS, aux bornes desquels est montée une diode en parallèle inverse. Le principe de la modulation par largeur d'impulsion consiste, pendant une période d'oscillation, à fermer successivement deux transistors situés en diagonale dans le pont, puis les deux autres, pendant un temps variable selon la consigne désirée.

Dans le domaine du nucléaire l'utilisation d'amplificateurs à découpage en zone active implique que l'électronique de puissance soit soumise au rayonnement nucléaire. Cette contrainte sur le choix des composants n'est pas nécessairement compatible avec les impératifs de rendement définis précédemment.

L'invention a également pour objet un système qui permette d'optimiser le rendement d'un amplificateur à découpage en minimisant le nombre de composants nécessaires et en le rendant résistant à une dose cumulée de rayonnements gamma comprise entre 10⁶ et 10⁷ rads.

L'invention concerne la commande d'actionneurs à courant continu par la technique de modulation par largeur d'impulsions, mise en oeuvre grâce à un pont de quatre transistors alimentés selon une diagonale du pont, la charge, donc l'actionneur, étant branchée dans la deuxième diagonale. La commande synchronisée de deux transistors opposés du pont, puis celle des deux autres permet de faire varier le courant moyen dans l'actionneur, donc le couple. L'actionneur peut être asservi en couple grâce à l'utilisation d'un capteur de mesure de ce courant moyen.

L'invention vise la commande d'un actionneur disposé en milieu radioactif ; à cet effet, elle se caractérise par la mise en oeuvre, pour constituer le pont, de transistors bipolaires résistant bien à l'irradiation et par un séquencement particulier des impulsions de commande des transistors qui ménage, entre les fronts de ces impulsions un temps minimal, tant pour celles qui commandent les transistors montés en série aux bornes de l'alimentation que pour celles qui commandent les transistors opposés du pont. La puissance dissipée par les transistors est ainsi réduite, le rendement du système étant amélioré.

Un brevet US-A-4 964 158 décrit en figure 8 un convertisseur continu-continu pour alimentation de sonnerie de téléphone. Il utilise le même pont et le même séquencement d'impulsions de commande des quatre transistors bipolaires, mais il ne constitue pas un système de commande en modulation par largeur d'impulsions, le signal de sortie étant une onde pseudoalternative, d'ailleurs fixée une fois pour toutes et ne permettant aucun asservissement.

Un brevet US-A-4 523 134 décrit un système d'alimentation pour moteur à courant continu, en modulation par largeurs d'impulsions. Le séquencement des impulsions de commande est tel que le recouvrement des impulsions relatives aux transistors opposés du pont est possible.

Une demande de brevet EP-A-0 578 555 décrit un système d'alimentation pour moteur synchrone triphasé qui met en oeuvre des transistors du type IGBT, et non bipolaires, et les commandes s'effectuent par des impulsions brèves, aptes à commander les IGBT mais incapables de s'appliquer aux transistors bipolaires.

### Exposé de l'invention

Le système de commande de moteur à courant continu de l'invention est basé sur le principe de la modulation par largeur d'impulsion utilisant un pont de quatre transistors bipolaires montés en H et permettant grâce au décalage de la mise en conduction et hors conduction des transistors d'une diagonale du pont, d'améliorer le rendement du système et de le rendre insensible aux dérives de paramètres des composants utilisés sous rayonnements gamma.

L'invention propose un système de commande d'actionneurs à courant continu en électronique de puissance, basé sur la modulation de largeur d'impulsion, comprenant un pont en H de quatre interrupteurs, chaque interrupteur comportant un transistor T1, T2, T3 ou T4 et une diode D1, D2, D3 ou D4 branchée en parallèle inverse sur ledit transistor, et un circuit de commande de ces transistors, caractérisé en ce que chaque transistor est du type bipolaire et en ce que le circuit de commande délivre quatre signaux V1, V2, V3 et V4 permettant de décaler dans le temps la commutation de ces quatre transistors T1, T2, T3 et T4, de manière à ce que lors d'une commutation de l'un de ceux-ci aucun couple de transistors ne soit rendu conducteur simultanément, tant en ce qui concerne les transistors appartenant à deux branches latérales du pont (c'est-à-dire dans deux branches situées entre les deux bornes d'alimentation continue du pont), qu'en ce qui concerne des transistors appartenant à deux branches opposées de ce pont. De préférence, pour commander les deux transistors T2 et T3 formant le bas du pont, ce circuit de commande délivre deux premiers signaux V2 et V3 envoyés respectivement sur la base de chacun de ces deux transistors par l'intermédiaire d'un montage de type "push-pull" pour adapter le niveau et la puissance et, pour commander les deux transistors T1 et T4 formant le haut du pont, il délivre deux seconds signaux envoyés respectivement sur la base de chacun de ces deux transistors par l'intermédiaire d'un isolement galvanique, réalisé par un transformateur de commande.

Tout en gardant le principe de la modulation par largeur d'impulsion, connue de l'homme de l'art, le système de l'invention utilise des transistors bipolaires, ce qui modifie les caractéristiques dudit système par rapport aux interrupteurs en "H" fonctionnant avec des transistors MOS.

Avantageusement, pour commander les transistors du haut du pont, le système de l'invention comprend une alimentation à découpage fonctionnant à partir d'un oscillateur attaquant un transformateur d'alimentation. Au secondaire de ce transformateur, le signal est redressé et filtré pour fournir des tensions +Va et -Va. Chacun des seconds signaux est surmodulé pour attaquer un transformateur de commande, celle surmodulation étant réalisée par le même oscillateur et une logique de modulation. Pour attaquer le transistor bipolaire de pont correspondant, le signal est démodulé à l'aide d'un redresseur et amplifié en l'adaptant en niveau.

Dans une réalisation avantageuse, le système de l'invention comprend quatre drivers et un mesureur de courant à effet Hall qui permet de fermer la boucle d'asservissement en courant, une résistance permettant de mesurer le courant pour une éventuelle mise en sécurité.

L'horloge du module logique de modulation est fabriquée par un oscillateur à trigger de Schmitt et une bascule D montée en diviseur par deux, ayant un rapport cyclique de 50 % pour éviter les composantes continues dans le transformateur. La modulation est réalisée par des portes logiques ET.

Le primaire de l'alimentation à découpage est réalisé avec la même horloge issue de la bascule suivie d'un étage à transistors de type "push-pull". Le transformateur est unique pour les deux alimentations à découpage de chacun des drivers hauts, les secondaires étant doubles et indépendants.

Le système de l'invention comprend deux drivers hauts dans lesquelles le secondaire de l'alimentation à découpage est constitué d'une part d'un redressement réalisé par quatre diodes de type "Schottky" pour limiter la chute de tension et, d'autre part, d'un filtrage réalisé par deux condensateurs pour obtenir ainsi deux tensions symétriques qui alimentent l'étage de puissance. Cet étage de puissance est constitué du transformateur d'impulsions qui permet de récupérer le signal modulé issu du module "logique de modulation", la démodulation étant réalisée par les deux diodes de type "Schottky" montées en redresseur avec point milieu, le signal ainsi redressé attaquant un amplificateur à transistors de type "push-pull", la masse flottante de l'alimentation étant reliée à l'émetteur du transistor de puissance.

Le système de l'invention présente de nombreux avantages :
- il offre un rendement optimal, les courts-circuits étant impossibles lors des commutations, et les transistors étant saturés au maximum, les performances de rendement étant comparables à celles obtenues avec des transistors MOS ;
- il offre une tenue optimale aux rayonnements gamma (supérieure à 10⁶ rads) grâce à l'utilisation de composants résistants aux rayonnements ;
- il présente un principe de fonctionnement simple et un nombre de composants nécessaires pour la mise en oeuvre réduit ;
- il ne nécessite pas l'utilisation de transistors de puissance très performants, en particulier en ce qui concerne la bande passante ;
- il peut être adapté en terme de courant et de tension simplement en changeant les transistors sans pour autant changer le principe ;
- il peut fonctionner en continu sur une branche du H, ce qui n'est pas toujours le cas pour d'autres principes de fonctionnement ;
- il est idéal pour la commande de moteurs à courant continu ayant une inductance faible grâce à sa fréquence de découpage élevée (35 KHz) ;
- il présente un principe transposable à d'autres types de moteurs, en particulier les moteurs synchrones auto pilotés ;
- il présente un coût de réalisation faible en raison de l'utilisation de composants standards du commerce.

### Brève description des dessins

- La figure 1 illustre un système de commande de l'art connu ;
- la figure 2 représente les signaux de commande du système illustré à la figure 1 ;
- la figure 3 représente les signaux de commande du système selon l'invention ;

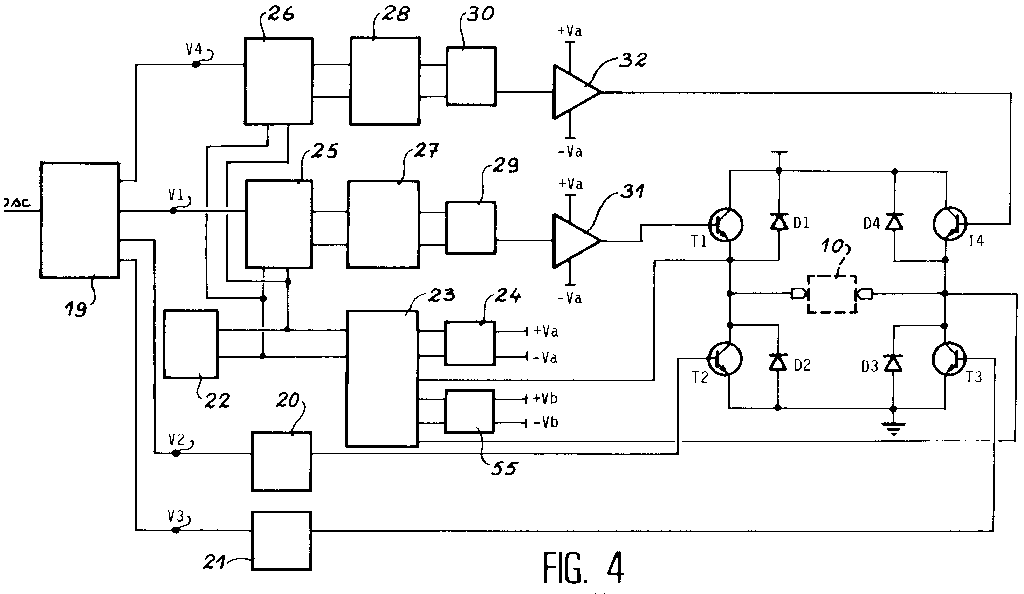

- la figure 4 illustre le système selon l'invention ;
- les figures 5 et 6 illustrent respectivement différentes courbes illustrant le fonctionnement d'un dispositif de l'art antérieur et celui du système de commande de l'invention ;
- les figures 7 à 10 illustrent un exemple de réalisation du système selon l'invention

### Exposé détaillé de modes de réalisation

En électronique de puissance, dans toute transformation la notion principale est celle de rendement. Le composant de base ne peut plus fonctionner en modulation car les pertes, produit du courant par la chute de tension, grèveraient trop lourdement le rendement. Il faut alors travailler en commutation ; le composant de base est le semi-conducteur de puissance fonctionnant en interrupteur. Quant "l'interrupteur" est ouvert, le courant qui le traverse doit être négligeable, même s'il est soumis à une tension élevée, afin que la puissance consommée soit minime. De même quand "l'interrupteur" est fermé, alors qu'il laisse passer un courant important, sa chute de tension interne doit être très faible pour que les pertes soient négligeables devant la puissance nominale.

Statiquement, le semi-conducteur de puissance joue un rôle analogue à celui d'un interrupteur mécanique :
- fermé ou passant, il laisse passer le courant en provoquant le moins de chute de tension possible ;
- ouvert ou bloqué, il ne laisse pas passer de courant malgré la tension apparaissant à ses bornes.

Les signaux de commande envoyés à un montage d'électronique de puissance ne servent qu'à fixer les instants d'entrée en conduction des "interrupteurs". La puissance correspondant à ces signaux de déblocage est très faible par rapport à celle traversant le montage.

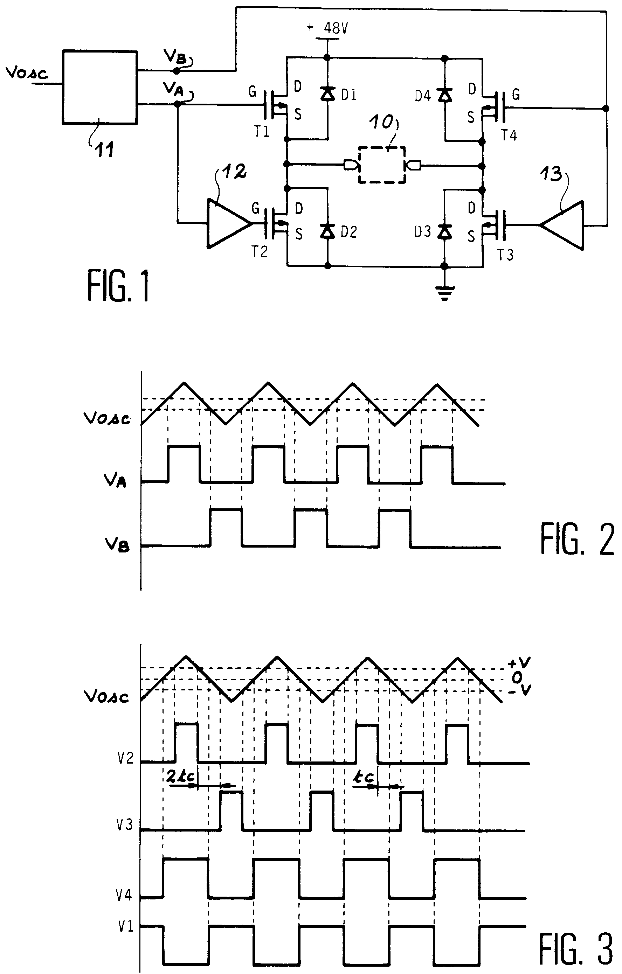

La figure 1 illustre un système de commande de l'art connu, dans lequel les interrupteurs sont des transistors MOS T1, T2, T3 et T4 montés sous forme de pont en H, la charge 10 étant au centre du H. On fixe une période d'oscillation dont la fréquence peut être de quelques kHz à quelques dizaines de kHz. Le principe de la modulation par largeur d'impulsion consiste, pendant cette période, à fermer successivement les transistors T1 et T3, puis T2 et T4 pendant un temps variable selon une consigne désirée V_{OSC}. Deux inverseurs 12 et 13 permettent d'inverser les signaux VA et VB pour commander les bases des transistors T2 et T3. Un circuit de commande 11 génère les signaux de commande des transistors. Ces circuits existent dans le commerce (par exemple : L292 de chez THOMSON, SG1731 de chez SILICON GENERAL, UDN1637 de chez UNITRODE). Des diodes D1, D2, D3 et D4 sont connectées en parallèle inverse des transistors. Ces dernières sont appelées "diodes de roues libres". Leur rôle est de permettre le passage de courants inverses dans les interrupteurs car les moteurs sont des éléments inductifs qui fournissent du courant. Il est donc nécessaire que chaque amplificateur soit réversible.

Dans le circuit de commande, comme représenté sur la figure 2, on part d'un signal en dents de scie V_{OSC}, on fabrique deux signaux VA et VB, correspondant aux signaux de commande des transistors, qui ménagent un "temps mort" entre les deux commutations des branches du H. Une variation de consigne est obtenue en ajoutant à la dent de scie V_{OSC} une composante continue qui fait varier la largeur des impulsions VA et VB, et donc le courant dans la charge.

Concrètement le signal VA pilote le transistor T1 directement et le transistor T2 à travers l'inverseur 12, et le signal VB pilote le transistor T4 directement et le transistor T3 à travers l'inverseur 13. Ce système permet d'avoir une certaine sécurité entre la commutation des deux branches du pont (grâce au "temps mort"), mais il y a risque de courts-circuits d'alimentation entre les transistors T1 et T2 d'une part et les transistors T3 et T4 d'autre part. En effet ils sont commandés simultanément à l'ouverture et à la fermeture. On comprend ainsi la volonté des concepteurs d'accélérer les temps de commutation et d'utiliser des composants de puissance rapides

Pour la conception d'amplificateurs, l'utilisation de transistors MOS présente de nombreux avantages ; ils sont notamment considérés comme plus simples à commander. Mais ces transistors MOS posent de gros problèmes au niveau de leur tenue aux rayonnements (destruction pour une dose cumulée inférieure à 100Krads).

Le cas des transistors IGBT, qui sont un assemblage d'un transistor MOS en entrée avec un transistor bipolaire en sortie, n'est pas résolu en ce qui concerne leur tenue aux rayonnements. L'utilisation de tels transistors IGBT est plutôt réservée aux fortes puissances sous des tensions importantes.

Si l'on utilise des transistors bipolaires, ceux-ci fonctionnent dans les deux modes décrits ci-dessus. Les interrupteurs de puissance conçus à base de transistors bipolaires permettent de commuter des puissances importantes. Un transistor à l'état passant fonctionne en régime saturé, c'est-à-dire que la chute de tension aux bornes est minimale. Pour réaliser cette condition on fournit un courant de base nécessaire (données constructeur). Dans l'autre cas il est bloqué, le courant de base est nul. D'un point de vue dynamique il est nécessaire de passer de l'état bloqué à l'état saturé des transistors le plus rapidement possible pour en particulier éviter les courts-circuits. Les constructeurs de transistors donnent les retards de mise en conduction et de blocage. Ceux-ci ne sont pas acceptables. On a donc recours à des systèmes d'aide à la commutation.

Les schémas et circuits d'aide à la commutation sont nombreux. On cite ci-dessous quelques exemples :
- pour réduire le temps d'amorçage, le courant de base doit croître aussi rapidement que possible. Pour cela on fournit une pointe de courant supérieure à la valeur nécessaire pour la saturation ;
- pendant la conduction, il faut que le courant de base soit suffisant pour assurer la saturation mais il doit éviter la sursaturation qui augmenterait fortement le temps de stockage à la fin de la phase conductrice. Pour ce faire on utilise une diode dite "antisaturation" entre base et collecteur ;
- pour réduire le temps de blocage il faut extraire de la base un courant inverse tout en limitant la rapidité de décroissance du courant de base. La solution consiste à bloquer le transistor avec une tension négative et d'évacuer ainsi plus rapidement les charges stockées dans la base.

Chaque modèle de transistor nécessite un montage particulier assez compliqué et volumineux, c'est pourquoi on utilise souvent des circuits intégrés spécifiques du commerce.

II faut aussi constater que l'attaque de ces transistors doit être la plupart du temps flottante, cela implique l'utilisation de composants d'isolation comme des optocoupleurs ou des transformateurs.

L'invention propose d'utiliser des transistors bipolaires qui sont particulièrement résistants aux rayonnements gamma, en évitant d'utiliser, pour la commande de ceux-ci, des composants complexes du commerce dont on ne connaît pas le comportement sous rayonnement et en utilisant un minimum de composants discrets.

L'invention ne propose pas un autre principe que la modulation par largeur d'impulsion pour commander le moteur ou d'essayer de commuter plus rapidement les transistors de puissance, mais elle consiste à considérer que l'on ne peut pas commuter plus rapidement ces interrupteurs ; on fait donc en sorte qu'ils n'aient pas besoin d'être rapides. L'invention propose donc un nouveau système au niveau de la commande tout en gardant le principe de la modulation par largeur d'impulsion.

Le principal problème du système de l'art antérieur réside dans le fait que les transistors sont commutés deux à deux. L'un passe de l'état bloqué à l'état saturé et l'autre de l'état saturé à l'état bloqué, ceci de manière instantanée.

L'idée de l'invention consiste à décaler dans le temps la commutation des quatre transistors de manière à ce que lors d'une commutation, aucun court-circuit ne soit possible. On s'autorise à décaler ces commutations d'autant qu'il le faut, c'est-à-dire d'un temps supérieur au temps de commutation maximum des transistors. On procède de la façon illustrée sur la figure 3.

On utilise donc un circuit de commande connu. On retrouve le générateur de dents de scie V_{OSC} et deux signaux de commande V2 et V3 équivalents à VA et VB vus précédemment. Ces derniers vont attaquer uniquement les transistors du bas T2 et T3. Les seuils +V et -V qui permettent de fabriquer les "temps morts" sont simplement ajustés de manière à ce que ces derniers soient égaux à deux fois le temps maximum de commutation d'un transistor (tc). Un troisième seuil zéro de tension est réalisé par un circuit extérieur (comparateur) ce qui permet de fabriquer les signaux V1 et V4, ces derniers vont attaquer les transistors T1 et T4. On remarque qu'ainsi les quatre transistors sont commutés à des instants différents séparés du temps tc.

Une séquence de commutation se déroule de la manière suivante :
- le transistor T1 est mis en état de conduction, mais comme les autres ne conduisent pas, on ne peut pas fournir de courant dans la charge ;
- le transistor T3 est mis en état de conduction, on peut fournir du courant dans la charge ;
- le transistor T3 est mis en état de haute impédance, on ne peut pas fournir de courant dans la charge ;
- le transistor T1 est mis en état de haute impédance et T4 est mis en état de conduction, on ne peut pas fournir de courant dans la charge ;
- le transistor T2 est mis en état de conduction, on peut fournir du courant dans la charge ;
- le transistor T2 est mis en état de haute impédance, on ne peut pas fournir de courant dans la charge.

La présence ou non de courant dans les transistors est aussi fonction de l'état du système au moment de la mise en conduction. C'est pourquoi on parle d'état de conduction et de possibilité de fournir du courant.

Cette commande implique une dissymétrie dans le montage, ce qui n'était pas le cas dans le système de l'art connu représenté à la figure 1.

L'interrupteur de puissance est constitué d'un transistor bipolaire avec sa diode de roue libre. Parmi les dispositifs d'amélioration de la commutation, seule la polarisation inverse de la base est utilisée.

Pour commander les transistors du bas T2 et T3, on utilise les signaux V2 et V3 obtenus en sortie du circuit de commande 19 directement, simplement en intercalant un montage de type "push-pull" 20, 21 pour adapter les niveaux et la puissance.

Pour commander les transistors du haut T1 et T4, on intercale un isolement galvanique entre les signaux V1 et V4 et le transistor considéré. Cet isolement est réalisé grâce à un transformateur de commande. La présence d'une isolation galvanique implique l'utilisation d'une alimentation flottante au niveau de l'amplificateur d'attaque. Cette dernière est une alimentation à découpage fonctionnant à partir d'un oscillateur 22 150KHz attaquant un transformateur 23. Au secondaire de ce dernier le signal est redressé et filtré (circuits 24 et 55) pour fournir des tensions +Va et -Va d'une part et des tensions +Vb et -Vb d'autre part. Le signal V1 (ou V4) est surmodulé dans une logique de modulation 25 (ou 26) pour attaquer le transformateur de commande 27 (ou 28) car il faut éviter les composantes continues dans ce dernier. Cette surmodulation est réalisée par le même oscillateur 22 et la logique de modulation. Il suffit ensuite pour attaquer le transistor de démoduler le signal à l'aide d'un redresseur 29(ou 30) et de l'amplifier (amplificateur 31 (ou 32)) en l'adaptant en niveau.

Dans les dispositifs de l'art antérieur, l'utilisation d'électronique de puissance sous rayonnements gamma pose le problème du comportement des composants de puissance en milieu ionisant. Dans le cas de la commande d'un moteur à courant continu, il est d'usage d'utiliser un pont en H de quatre transistors au milieu duquel la charge est connectée (voir la figure 1). En milieu industriel les transistors de type MOS ou IGBT sont souvent utilisés, ici on s'intéresse uniquement à l'emploi de transistors bipolaires pour des raisons de tenue à la dose cumulée de rayonnements gamma.

La commande du pont en H est réalisée selon le principe suivant (voir la figure 2). Les transistors T1 et T3 sont fermés simultanément puis les transistors T2 et T4. On fait varier la durée de conduction d'une diagonale du pont par rapport à l'autre tout en gardant la période constante (principe de la modulation par largeur d'impulsion). Un temps tc pendant lequel aucun transistor n'est conducteur est aménagé afin d'éviter tout court circuit d'alimentation par l'intermédiaire de T1 et T2 d'une part et T3 et T4 d'autre part.

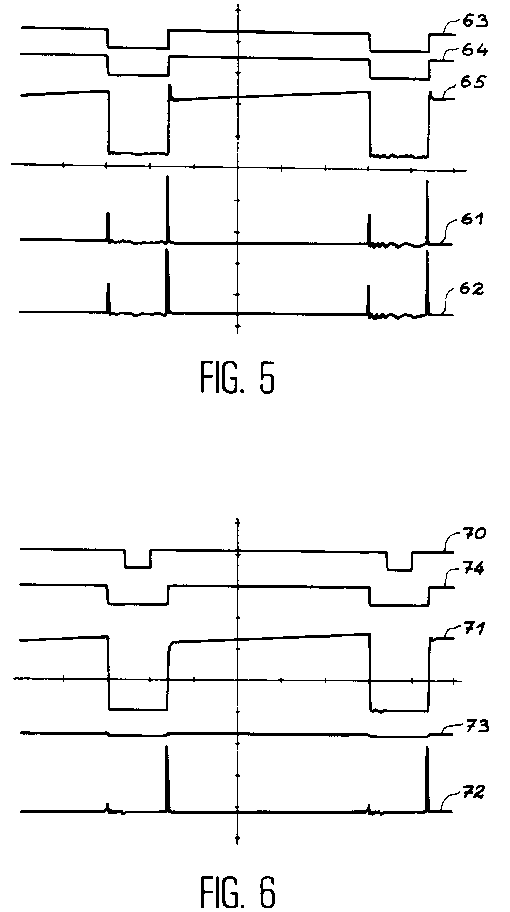

La puissance dissipée par les deux transistors T1 et T3 (simulation SPICE) est représentée sur la figure 5. Sur cette figure on a respectivement :
- un signal 61 : puissance dans T1 ;
- un signal 62 : puissance dans T3 ;
- un signal 63 : VA commande T1 ;
- un signal 64 : VB commande T3 ;
- un signal 65 : courant collecteur.

On peut observer que la puissance à dissiper est répartie uniformément sur les deux transistors. Elle se divise en une puissance statique continue dont la cause est la tension de saturation du transistor, et une puissance dynamique dont les causes sont les temps de commutation.

L'amélioration du rendement d'un tel montage passe par l'optimisation des pertes dans les transistors. D'un point de vue statique il est nécessaire de saturer les transistors au maximum ; d'un point de vue dynamique il est nécessaire d'accélérer les commutations au maximum. La sursaturation d'un transistor provoque l'allongement des temps de commutation, il s'agit donc d'un compromis.

Comme décrit précédemment, on utilise généralement des montages plus ou moins complexes pour accélérer les commutations. Ces derniers sont souvent pointus pour leurs réglages et travaillent aux limites des possibilités des composants, et ont pour effet d'augmenter la puissance statique due à la tension de saturation des transistors.

De tels montages sont difficiles à utiliser sous rayonnements gamma, car les paramètres des composants employés sont susceptibles d'évoluer de manière importante et d'avoir des conséquences catastrophiques sur les performances d'un amplificateur. En particulier les tensions de saturation des transistors (Vcesat) sont susceptibles d'augmenter sous rayonnements gamma.

Dans la solution proposée par l'invention, on a choisi de simplifier les étages d'attaque des interrupteurs et de privilégier l'aspect statique en saturant pleinement les transistors. La conséquence est l'allongement des durées de commutation du système de l'invention. Afin de minimiser les pertes dynamiques, on a modifié le séquencement de mise en conduction des transistors comme suit (voir la figure 3).

Tout en gardant le temps tc pendant lequel aucun transistor n'est conducteur, mais contrairement aux systèmes utilisés dans l'art antérieur, dans le système de l'invention les transistors T1 et T3 qui reçoivent les signaux V1 et V3 d'une part et les transistors T2 et T4 qui reçoivent les signaux V2 et V4 d'autre part ne sont pas rendus conducteurs simultanément. T1 ou T4 sont tout d'abord mis en état de conduction ; après un temps tc supérieur au temps de recouvrement des transistors utilisés, les transistors T2 ou T3 sont à leur tour rendus conducteurs et le courant commence à circuler. Après un temps variable selon la commande désirée, les transistors T2 ou T3 sont rendus non conducteurs et le courant est annulé. Après un temps tc les transistors T1 ou T4 sont mis hors d'état de conduction.

La puissance dissipée par les deux transistors T1 et T3 (simulation SPICE) est alors représentée sur la figure 6. Sur cette figure 6, on a respectivement :
- un signal 70 : V3 commande de T3 ;
- un signal 71 : courant collecteur ;
- un signal 72 : puissance dans T3 ;
- un signal 73 : puissance dans T1 ;
- un signal 74 : V1 commande de T1.

On peut observer que le transistor T1 n'a pas de puissance dynamique à dissiper mais seulement une puissance statique. Le transistor T3 supporte seul une puissance dynamique et statique. Le bilan global des puissances dissipées permet d'améliorer le rendement de l'amplificateur.

Dans un exemple de réalisation, un amplificateur destiné à piloter un moteur à courant continu de robot fonctionnant dans un milieu hostile, est capable de fournir un courant de 10A sous une tension de 60V. Il est asservi en courant et peut piloter le moteur en vitesse. Il présente un rendement qui le rend utilisable dans une application de type industrielle.

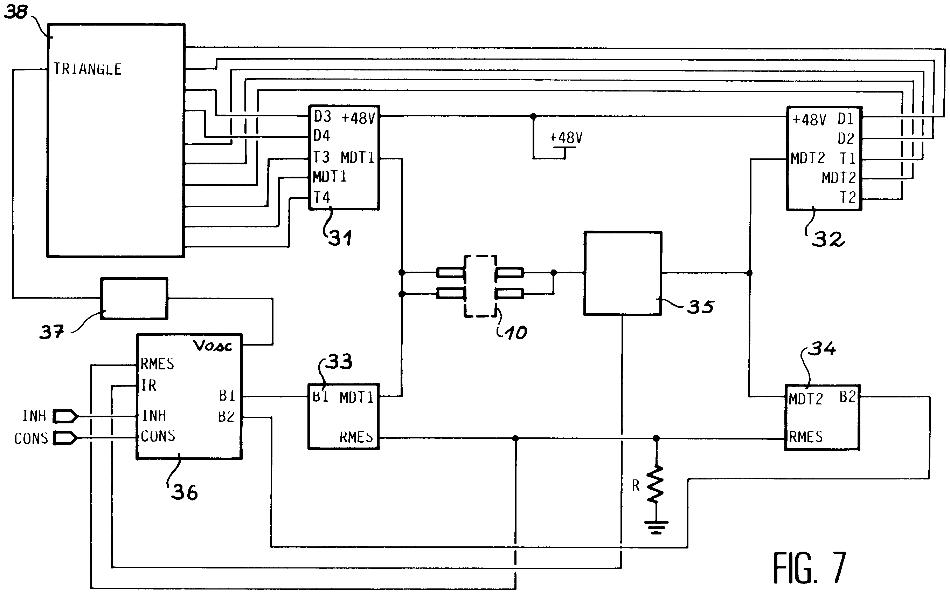

La partie asservissement de vitesse de l'amplificateur qui ne fait pas l'objet de la présente invention n'est pas décrite ici. Le synoptique illustré à la figure 7 présente les différents modules qui constituent cet amplificateur.

Le pont en H est symbolisé par les quatre drivers 31, 32, 33 et 34 qui sont en fait les interrupteurs de puissance. La charge 10 se trouve sur la barre horizontale du H. Un mesureur de courant à effet Hall 35 permet de fermer la boucle d'asservissement de courant. Une résistance R permet de mesurer le courant pour une éventuelle mise en sécurité.

On retrouve le circuit de commande 36 qui reçoit les consignes de courant du module d'asservissement (non représenté ici). Ce dernier fournit d'une part les signaux B1 et B2 équivalents aux signaux V2 et V3 définis précédemment et, d'autre part, après passage dans un comparateur 37, le signal "triangle" équivalent au signal V_{OSC}. Les signaux B1 et B2 permettent d'attaquer les deux drivers bas.

On retrouve également le module "logique de modulation" 38 qui fabrique les signaux d'attaque des drivers hauts.

Le circuit de commande 36 est la partie "intelligente" de l'amplificateur. Il est constitué par exemple du circuit UDN3637 de la société UNITRODE. Ce dernier, grâce à un certain nombre de composants discrets, fabrique les signaux B1 et B2 d'attaque des drivers bas. Il reçoit les signaux :
- CONS : signal de consigne de courant de l'asservissement ;
- IR : retour du signal de courant mesuré pour l'asservissement de courant ;
- RMES : retour du signal de courant mesuré pour la limitation de courant ;
- INH : entrée inhibition de l'amplificateur.

Ce circuit 36 laisse à la disposition de l'utilisateur le signal V_{OSC}. Il est utilisé ici pour engendrer le signal "triangle" qui est fabriqué grâce au comparateur 37.

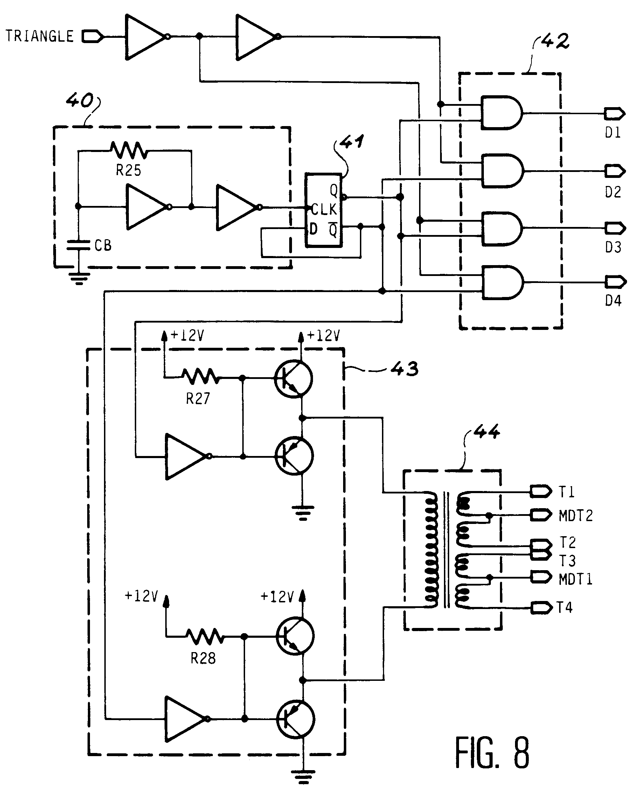

Le module logique de modulation 38, représenté sur la figure 8, reçoit le signal "triangle" qui est le signal à moduler. L'horloge de modulation est fabriquée par un oscillateur 40 à trigger de Schmitt (figure 8) et une bascule D 41 montée en diviseur par deux. Cette dernière doit avoir un rapport cyclique de 50 % pour éviter les composantes continues dans le transformateur. La modulation est réalisée par des portes logiques ET 42 qui reçoivent d'une part le signal "triangle" et son inverse à moduler et, d'autre part, l'horloge. Deux sorties attaquent le transformateur du driver haut 31 et deux sorties attaquent le transformateur du driver haut 32.

Le primaire de l'alimentation à découpage est réalisé avec la même horloge issue de la bascule 41 suivie d'un étage à transistors de type "push-pull" 43. Le transformateur 44 est unique pour les deux alimentations à découpage de chacun des drivers hauts. Les secondaires sont doubles et indépendants.

Dans un exemple de réalisation on peut avoir des composants ayant les valeurs suivantes :
R25 = R27 = R28 = 470 Ω
R26 = 4,7 KΩ
C8 = 4,7 nF.

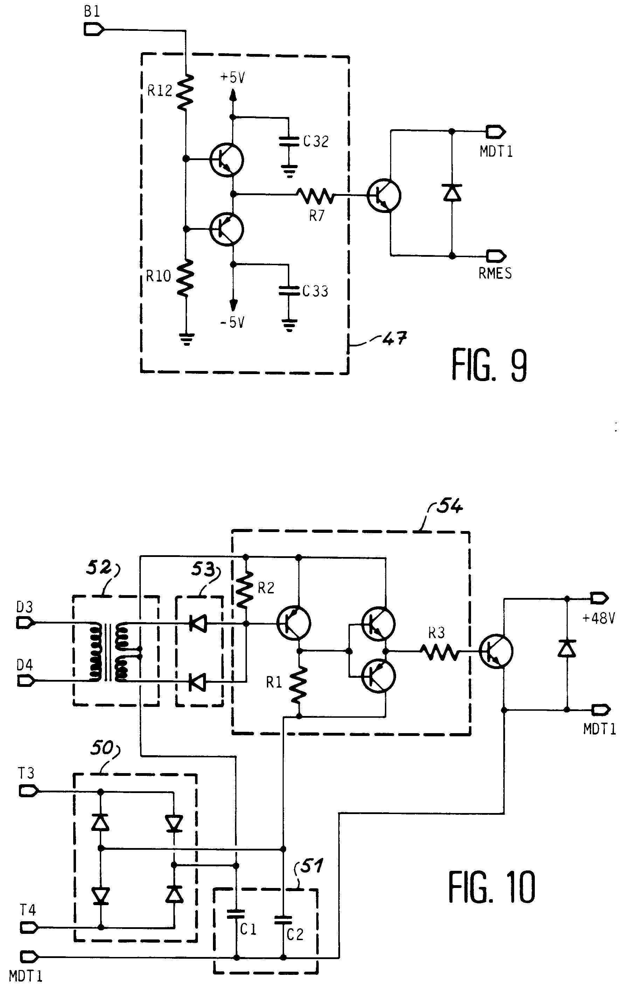

Le driver bas, représenté sur la figure 9, est simplement constitué d'un étage d'amplification à transistors de type "push-pull" 47 et de l'interrupteur de puissance proprement dit. Ce dernier peut utiliser des transistors de puissance MOTOROLA du type BUS 36, ainsi qu'une diode de roue libre MUR 460 du même constructeur.

L'attaque est faite par le point B1 et est nécessairement référencée par rapport à la masse.

Dans un exemple de réalisation, on peut avoir des composants ayant les valeurs suivantes :
R12 = 380 Ω
R10 = 220 Ω
R7 = 12 Ω
C32 = C33 = 0,1 µF.

Le driver haut, représenté sur la figure 10, est constitué de deux parties essentielles.

Le secondaire de l'alimentation à découpage constitué d'une part d'un redressement 50 réalisé par quatre diodes de type "schottky" par exemple 1N 5818 pour limiter la chute de tension et, d'autre part, d'un filtrage 51 réalisé par deux condensateurs. On obtient ainsi deux tensions symétriques de +4V et -4V qui alimentent l'étage de puissance.

L'étage de puissance est constitué du transformateur d'impulsion 52 qui permet de récupérer le signal modulé issu du module "logique de modulation". La démodulation est réalisée par les deux diodes 53 de type "schottky" montées en redresseur avec point milieu. Le signal ainsi redressé attaque un amplificateur à transistors de type "push-pull" 54. La masse flottante de l'alimentation est reliée à l'émetteur du transistor de puissance.

La diode de roue libre n'est pas identique à celle des drivers bas. Ce peut être une diode de type MBR 10100 de MOTOROLA. En effet, il ne faut pas oublier que le montage n'est pas symétrique. Sur les drivers hauts la phase de conduction des transistors est plus courte, ce qui augmente le temps de conduction des diodes, d'où l'utilisation de composants plus puissants.

Dans un exemple de réalisation, on peut avoir des composants ayant les valeurs suivantes :
R2 = 47 Ω
R1 = 560 Ω
R3 = 3,9 Ω
C1 = C2 = 15 µF.

Les applications potentielles d'un tel système peuvent toucher deux domaines :
- le domaine de l'électronique durcie :
   · pour le nucléaire civil : ce principe est idéal pour alimenter les actionneurs des machines d'inspection ou d'intervention lorsque ces dernières sont mobiles et demandent du matériel compact et performant. Le bon rendement de cet amplificateur lui permet de prolonger l'autonomie de ces systèmes, son faible volume permet de le loger plus facilement dans un système embarqué. Dans ce même domaine du nucléaire, ce principe peut être utilisé pour alimenter les actionneurs des bras de télé manipulation. L'amplificateur peut être placé au pied du bras en zone "chaude". Il fonctionne sans dérive notable de paramètre au delà d'une dose intégrée de 10⁶ rads. Il peut permettre ainsi d'éviter le passage d'un câble de section importante qui pose de gros problèmes entre la cellule et l'extérieur,
   · hors nucléaire civil : ce principe peut être utilisé dans les autres domaines impliquant la présence de rayonnements ionisants comme le spatial, le militaire et le médical ;
- le domaine industriel : ce principe est tout à fait compatible avec les exigences d'un produit industriel en ce qui concerne ses performances et son prix de revient qui n'est pas plus important que celui d'un autre amplificateur industriel. Le principe est aussi adaptable d'une part à d'autres courants et tensions par changement des interrupteurs de puissance et , d'autre part, à d'autres types de moteurs comme les moteurs synchrones auto pilotés.

## Revendications

1. Système de commande d'actionneurs à courant continu en électronique de puissance, basé sur la modulation de largeur d'impulsion, comprenant un pont en H de quatre interrupteurs, chaque interrupteur comportant un transistor (T1, T2, T3, T4) et une diode (D1, D2, D3, D4) branchée en parallèle inverse entre l'émetteur et le collecteur de celui-ci, et un circuit de commande (11) de ces transistors, caractérisé en ce que chaque transistor (T1, T2, T3, T4) est du type bipolaire et en ce que le circuit de commande (11) délivre quatre signaux (V1, V2, V3, V4) permettant de décaler dans le temps la commutation de ces quatre transistors (T1, T2, T3, T4) de manière à ce que lors d'une commutation de l'un de ceux-ci aucun couple de transistors ne soit rendu conducteur simultanément, tant en ce qui concerne les transistors appartenant à deux branches latérales du pont, qu'en ce qui concerne les transistors appartenant à deux branches opposées de ce pont..

2. Système selon la revendication 1, caractérisé en ce que, pour commander les deux transistors (T2, T3) formant le bas du pont, il délivre deux premiers signaux (V2, V3) envoyés respectivement sur la base de chacun de ces deux transistors par l'intermédiaire d'un montage de type "push-pull" pour adapter le niveau et la puissance.

3. Système selon la revendication 1, caractérisé en ce que, pour commander les deux transistors (T1, T4) formant le haut du pont, il délivre deux seconds signaux envoyés respectivement sur la base de chacun de ces deux transistors par l'intermédiaire d'un isolement galvanique, réalisé par un transformateur de commande (27, 28).

4. Système selon la revendication 1, caractérisé en ce que, pour commander les transistors du haut du pont, il comprend deux alimentations à découpage fonctionnant à partir d'un oscillateur (22) attaquant un transformateur d'alimentation (23) ; en ce que, au secondaire de ce transformateur, le signal est redressé et filtré pour fournir des tensions +Va et -Va et Vb et -Vb ; en ce que chacun des seconds signaux (V1, V4) est surmodulé pour attaquer un transformateur de commande, cette surmodulation étant réalisée par le même oscillateur (22) et une logique de modulation (25, 26) ; et en ce que pour attaquer le transistor bipolaire de pont correspondant, le signal est démodulé à l'aide d'un redresseur (29, 30) et amplifié (31, 32) en l'adaptant en niveau.

5. Système selon la revendication 1, caractérisé en ce qu'il comprend quatre drivers (31, 32, 33, 34), et un mesureur de courant à effet Hall (35) qui permet de fermer la boucle d'asservissement en courant, et une résistance (R) permettant de mesurer le courant pour une éventuelle mise en sécurité.

6. Système selon la revendication 5, caractérisé en ce que l'horloge du module logique de modulation est fabriquée par un oscillateur (40) à trigger de Schmitt et une bascule D (41) montée en diviseur par deux, ayant un rapport cyclique de 50% pour éviter les composantes continues dans le transformateur ; et en ce que la modulation est réalisée par des portes logiques ET (42).

7. Système selon la revendication 6, caractérisé en ce que le primaire de l'alimentation à découpage est réalisé avec la même horloge issue de la bascule (41) suivie d'un étage à transistors de type "push-pull" (43) ; et en ce que le transformateur (44) est unique pour les deux alimentations à découpage de chacun des drivers hauts, les secondaires étant doubles et indépendants.

8. Système selon la revendication 5, caractérisé en ce qu'il comprend deux drivers hauts dans lesquels le secondaire de l'alimentation à découpage est constitué d'une part d'un redressement (50) réalisé par quatre diodes de type "schottky" pour limiter la chute de tension et, d'autre part, d'un filtrage (51) réalisé par deux condensateurs pour obtenir ainsi deux tensions symétriques qui alimentent l'étage de puissance ; et en ce que cet étage de puissance est constitué du transformateur d'impulsions (52) qui permet de récupérer le signal modulé issu du module "logique de modulation", la démodulation étant réalisée par les deux diodes (53) de type "schottky" montées en redresseur avec point milieu, le signal ainsi redressé attaquant un amplificateur à transistors de type "push-pull" (54), la masse flottante de l'alimentation étant reliée à l'émetteur du transistor de puissance.
